# EUROPEAN PATENT APPLICATION

(11) **EP 3 471 131 A1**
(43) Date of publication of application: **17.04.2019**
(21) Application number: 17813207.2
(22) Date of filing: 08.06.2017
(51) Int. Cl.: H01L 21/31, B24B 19/02, B24D 5/00, C03C 19/00, C23C 16/44

(54) **QUARTZ GLASS MEMBER WITH INCREASED EXPOSED AREA, METHOD FOR MANUFACTURING SAME, AND BLADE WITHI MULTIPLE PERIPHERAL CUTTING EDGES**

(30) Priority: 14.06.2016 JP 2016118118
(71) Applicant: Shin-Etsu Quartz Products Co., Ltd., Tokyo 160-0023 (JP); Fukui Shin-Etsu Quartz Products Co., Ltd., Echizen-shi, Fukui 915-0037 (JP)
(72) Inventor: TSUCHIDA, Akiyoshi, Echizen-shi Fukui 915-0037 (JP); FUJII, Norikazu, Tokyo 160-0023 (JP); MAKIDA, Yoshiki, Echizen-shi Fukui 915-0037 (JP)
(74) Representative: Grünecker Patent- und Rechtsanwälte PartG mbB
(86) International application number: PCT/JP2017/021265
(87) International publication number: WO 2017/217309

(57) **Abstract**

Provided are a quartz glass member with an increased exposure area, which has an increased exposure area to a film formation treatment gas as compared to a member having a flat surface and has the increased exposure area controlled so that a constant adsorption amount of the film formation treatment gas onto a surface thereof is achieved, a method for manufacturing the quartz glass member with an increased exposure area, and a blade with multiple peripheral cutting edges to be used for the method. The quartz glass member with an increased exposure area is a quartz glass member for exposure to a film formation treatment gas to be, in film formation treatment of a semiconductor substrate, placed in a reaction chamber together with the semiconductor substrate to be subjected to the film formation treatment and exposed to the film formation treatment gas, the quartz glass member including: a quartz glass member main body; and a plurality of irregularities formed on a surface of the quartz glass member main body, the exposure area of the quartz glass member to the film formation treatment gas being controlled and increased.

## Description

### Technical Field

The present invention relates to a quartz glass member with an increased exposure area, which is a quartz glass member for exposure to be, in film formation treatment of a semiconductor substrate, placed in a reaction chamber together with the semiconductor substrate to be subjected to the film formation treatment, the quartz glass member having an increased exposure area to a film formation treatment gas as compared to a member having a flat surface, and having the increased exposure area controlled so that a constant adsorption amount of the film formation treatment gas onto a surface thereof is achieved, a method of manufacturing the quartz glass member with an increased exposure area, and to a blade with multiple peripheral cutting edges to be used for the method.

### Background Art

In a manufacturing process for a semiconductor device, various film formation treatments, such as chemical vapor deposition (CVD), have hitherto been performed on a semiconductor substrate, such as a silicon wafer. In performing each of the film formation treatments, the semiconductor substrate is mounted on, for example, a wafer-holding jig called a wafer boat or a susceptor and carried into a reaction chamber, and the film formation treatment is performed.

In such film formation treatment using the wafer-holding jig, in some cases, the wafer boat is formed of quartz glass, which is a material non-reactive with a treatment gas, the semiconductor substrate is mounted on such wafer boat and housed in the reaction chamber together with a member formed of quartz glass, which is a material non-reactive with the treatment gas, and the film formation treatment is performed. An example of such film formation method is described in Patent Document 1.

In general, such technology is intended to provide a member aimed at reducing a variation in gas flow around the wafer. However, in the film formation treatment, there arises a problem in that a film cumulatively adheres onto such member as in the case of the semiconductor substrate, with the result that foreign manner is generated owing to peeling of the film and breakage occurs owing to a difference in expansion between the member and the film. Therefore, various efforts have been made.

Incidentally, the semiconductor substrate to be subjected to the film formation treatment has, on a surface thereof, irregularities formed through the treatment, and thus has an increased surface area as compared to a semiconductor substrate having a flat surface. In view of the foregoing, in order to achieve uniform film formation on the semiconductor substrate, there is a need to increase also the surface area of a quartz glass member to be exposed to a film formation treatment gas in the reaction chamber, to thereby control the adsorption amount of the film formation treatment gas in accordance with the irregularities formed on the surface of the semiconductor substrate.

Further, as the film thickness of a film formed through film formation is reduced, the quartz glass member needs to accomplish the task of achieving uniform film formation on the uniform semiconductor substrate by controlling the adsorption amount of the film formation gas, rather than the task of reducing the variation in gas flow. In increasing the exposure area of the quartz glass member to the film formation treatment gas and accurately controlling adsorption of the film formation treatment gas, it has been significantly difficult to achieve a quartz glass member having an increased surface area with high accuracy and high production efficiency.

### Prior Art Documents

### Patent Documents

Patent Document 1: JP Hei 07-99157 A

### Summary of the Invention

### Problems to be solved by the Invention

The present invention has been made in view of the above-mentioned problems of the related art, and an object of the present invention is to provide a quartz glass member with an increased exposure area, which has an increased exposure area to a film formation treatment gas as compared to a member having a flat surface and has the increased exposure area controlled so that a constant adsorption amount of the film formation treatment gas onto a surface thereof is achieved, a method of manufacturing the quartz glass member with an increased exposure area, and a blade with multiple peripheral cutting edges to be used for the method.

### Means for Solving the Problems

A quartz glass member with an increased exposure area according to the present invention is a quartz glass member with an increased exposure area, which is a quartz glass member for exposure to a film formation treatment gas to be, in film formation treatment of a semiconductor substrate, placed in a reaction chamber together with the semiconductor substrate to be subjected to the film formation treatment and exposed to the film formation treatment gas, the quartz glass member including: a quartz glass member main body; and a plurality of irregularities formed on a surface of the quartz glass member main body, the exposure area of the quartz glass member to the film formation treatment gas being controlled and increased. It is preferred that the exposure area be controlled so that a constant adsorption amount of the film formation treatment gas onto an exposure surface is achieved.

It is preferred that the plurality of irregularities controlled and increased have groove shapes, and variations in groove width and groove depth of the grooves each fall within a range of ±20%.

A method of manufacturing a quartz glass member with an increased exposure area according to the present invention is a method of manufacturing the quartz glass member with an increased exposure area, including performing simultaneous processing of a plurality of grooves on the surface of the quartz glass member main body through use of a blade with multiple peripheral cutting edges, to thereby form the plurality of irregularities.

It is preferred that the quartz glass member with an increased exposure area obtained through the groove processing have, on one surface thereof having been subjected to the groove processing, a surface area three times or more as large as a surface area of the quartz glass member with an increased exposure area on the one surface before the groove processing.

A blade with multiple peripheral cutting edges according to the present invention is a blade with multiple peripheral cutting edges for performing the groove processing in the method of manufacturing the quartz glass member with an increased exposure area, the blade with multiple peripheral cutting edges including: a single disc-shaped base metal portion; a diamond abrasive grain layer base portion formed at an outer periphery of the disc-shaped base metal portion; and a diamond abrasive grain cutting edge portion in which a plurality of cutting edges are integrally formed so as to protrude from the diamond abrasive grain layer base portion.

It is preferred that the diamond abrasive grain cutting edge portion have a ratio between a cutting edge thickness and a cutting edge length of each of the plurality of cutting edges of 1:5 or more.

It is preferred that the diamond abrasive grain layer base portion have a thickness twice or more as large as a cutting edge length of each of the plurality of cutting edges of the diamond abrasive grain cutting edge portion.

It is preferred that the diamond abrasive grain layer base portion have an arc-like depression formed on a surface thereof between the plurality of cutting edges.

### Advantageous Effects of the Invention

The present invention exhibits remarkable effects of enabling provision of the quartz glass member with an increased exposure area, which has an increased exposure area to a film formation treatment gas as compared to a member having a flat surface and has the increased exposure area controlled so that a constant adsorption amount of the film formation treatment gas onto a surface thereof is achieved, the method of manufacturing the quartz glass member with an increased exposure area, and the blade with multiple peripheral cutting edges to be used for the method.

### Brief Description of Drawings

FIGS. 1 are each a schematic plan view for illustrating an example of a quartz glass member with an increased exposure area of the present invention. FIGS. 1(a) and 1(b) are each an illustration of an example of a ring-shaped quartz glass member, and FIGS. 1(c) and 1(d) are each an illustration of an example of a disc-shaped quartz glass member.
FIGS. 2 are illustrations of an example of groove processing of the quartz glass member with an increased exposure area of the present invention. FIG. 2 (a) is an enlarged schematic view for illustrating a surface of the quartz glass member having been subjected to the groove processing, and FIG. 2 (b) is an enlarged schematic view for illustrating the surface before the groove processing.
FIGS. 3 are each a view for illustrating a blade with multiple peripheral cutting edges of the present invention. FIG. 3(a) is a schematic perspective view, and FIG. 3(b) is a schematic front view.
FIG. 4 is an enlarged schematic sectional view of a main portion of the blade with multiple peripheral cutting edges of the present invention.
FIG. 5 is a schematic plan view for illustrating a situation in which processing of a plurality of grooves is performed through use of the blade with multiple peripheral cutting edges of the present invention.
FIG. 6 is a schematic side view for illustrating the situation in which processing of a plurality of grooves is performed through use of the blade with multiple peripheral cutting edges of the present invention.
FIG. 7 is a schematic view for illustrating an example of a vertical heat treatment furnace.
FIG. 8 is a schematic sectional view for illustrating a film formation treatment apparatus used in each of Examples 11 and 12 and Comparative Example 1.
FIG. 9 is a schematic front view for illustrating a related-art blade with multiple peripheral cutting edges.

### Description of Embodiments

Embodiments of the present invention are described below, but these embodiments are described as examples, and hence it is understood that various modifications may be made thereto without departing from the technical spirit of the present invention. In the drawings, the same members are denoted by the same reference symbols.

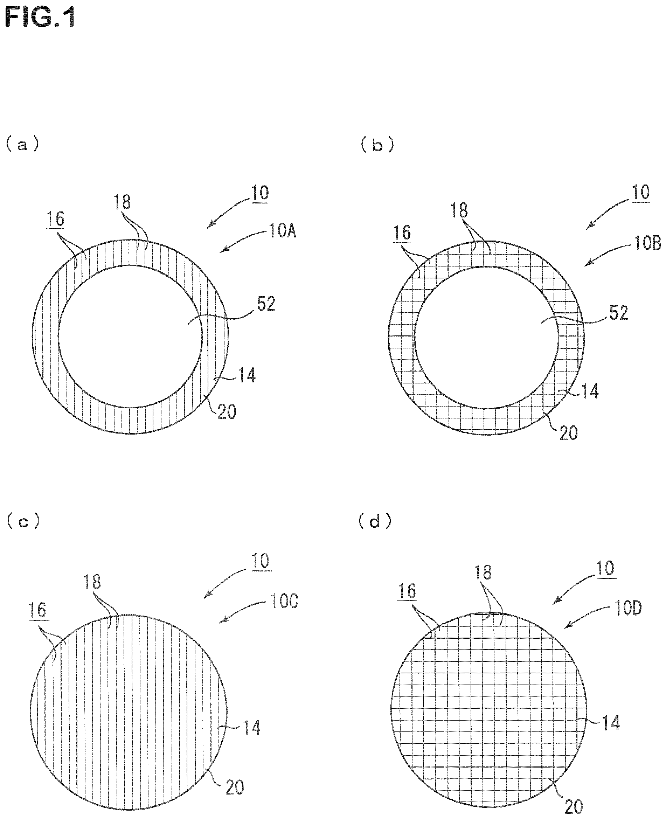

In each of FIGS. 1(a) to 1(d), FIG. 7, and FIG. 8, a quartz glass member with an increased exposure area of the present invention is denoted by reference numeral 10. A quartz glass member 10 with an increased exposure area is a quartz glass member for exposure to a film formation treatment gas to be, in film formation treatment of a semiconductor substrate W, placed in a reaction chamber 12 together with the semiconductor substrate W to be subjected to the film formation treatment and exposed to the film formation treatment gas, the quartz glass member including: a quartz glass member main body 14; and a plurality of irregularities 16 formed on a surface of the quartz glass member main body 14, an exposure area of the quartz glass member to the film formation treatment gas being increased.

In the present invention, the shape of the quartz glass member main body 14 is not particularly limited. Any shape of the member and any processing of the irregularities suitable for controlling the film formation treatment gas based on film formation conditions may appropriately be selected, but a plate shape is preferred. Examples of the plate shape include a circular plate shape and a polygonal plate shape. In the illustrated examples, examples of a circular plate shape having a hollow central portion (ring shape) in a plan view are illustrated in FIGS. 1(a) and 1(b), and examples of a disc shape without a hollow central portion (wafer shape) in a plan view are illustrated in FIGS. 1(c) and 1(d).

In FIG. 1(a), the hollow portion is denoted by reference numeral 52. A quartz glass member main body 14 of a ring-shaped quartz glass member 10A with an increased exposure area has a circular shape having a hollow central portion, and parallel grooves 18 serving as the plurality of irregularities 16 are formed at regular intervals on the entirety of a surface of the quartz glass member main body 14. A quartz glass member 10B with an increased exposure area of FIG. 1(b) is the same as the quartz glass member 10A with an increased exposure area of FIG. 1(a) except that 90° crossed grooves 18 serving as the plurality of irregularities 16 are formed.

A quartz glass member main body 14 of a quartz glass member 10C with an increased exposure area of FIG. 1(c) has a disc shape without a hollow central portion in a plan view, and parallel grooves 18 serving as the plurality of irregularities 16 are formed at regular intervals on the entirety of a surface of the quartz glass member main body 14. A quartz glass member 10D with an increased exposure area of FIG. 1(d) is the same as the quartz glass member 10C with an increased exposure area of FIG. 1(c) except that 90° crossed grooves 18 serving as the plurality of irregularities 16 are formed.

The examples in each of which a plurality of grooves 18 serving as the plurality of irregularities 16 are formed at regular intervals are illustrated, but it is appropriate to adopt different intervals between a center and a periphery in order to control the adsorption amount of the film formation treatment gas. The shape of each of the plurality of irregularities 16 is not particularly limited as long as the plurality of irregularities are formed on the surface, but is preferably a groove shape. The groove shape may have a linear form, a curved form, a circumferential form, or a broken line form, and is not particularly limited. Of those, a linear form is preferred. A plurality of linear grooves may be parallel to one another or intersect with one another, but preferably have a parallel pattern or a cross pattern as illustrated in FIGS. 1(a) to 1(d). In addition, a plurality of kinds of shapes may be used in combination.

While the plurality of grooves 18 obtained through accurate groove processing or the like form the plurality of irregularities 16, the plurality of irregularities 16 may be formed on only one surface or on both surfaces of the quartz glass member main body 14. In addition, the plurality of irregularities 16 may be formed on the entirety or on part of the surface of the quartz glass member main body 14. However, the plurality of irregularities 16 are preferably formed on the entirety or on at least an outer periphery of the surface.

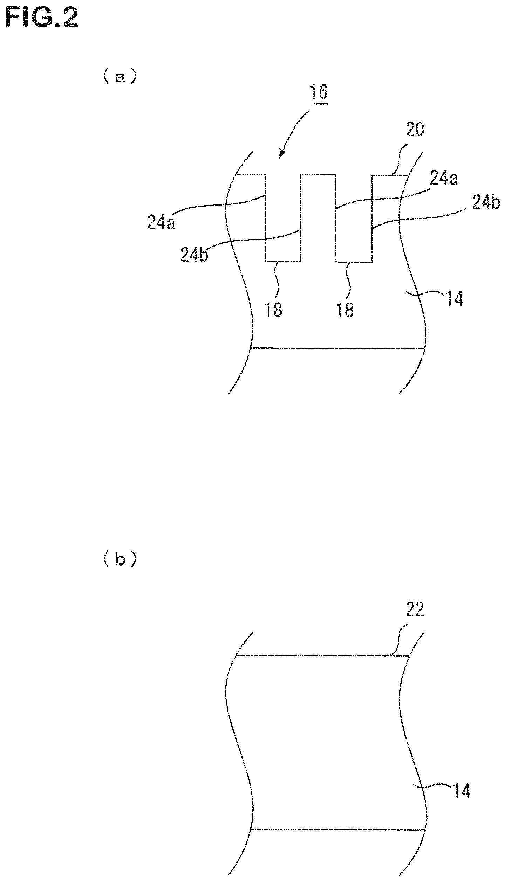

In FIGS. 2, one surface of the quartz glass member 10 with an increased exposure area having been subjected to groove processing and the surface before the groove processing are illustrated.

When the plurality of grooves 18 are formed on one surface 20 through the groove processing as illustrated in FIG. 2(a), the area of the surface is increased according to inner side surfaces 24a and 24b of the grooves 18 as compared to a flat surface 22 before the groove processing as illustrated in FIG. 2(b). Accordingly, when the grooves 18 are formed on the surface 20 as illustrated in FIG. 2(a), the surface 20 is increased in exposure area to the film formation treatment gas as compared to the flat surface 22 before the groove processing as illustrated in FIG. 2(b). Therefore, the width and depth of the grooves 18 are important factors for accurate control of the increased exposure area, and by extension, the adsorption amount of the film formation treatment gas.

For example, the width and depth of the grooves 18 may each appropriately be selected within a range of from 0.05 mm to 1.5 mm depending on the increased area corresponding to a required adsorption amount. However, when a ratio between the groove width and the groove depth exceeds 1:10, the treatment gas to be adsorbed is not stably supplied to the bottoms of the grooves. Meanwhile, when the ratio is less than 1:1, an effect of the increased area is not sufficiently obtained. Therefore, the ratio between the groove width and the groove depth is preferably from 1:1 to 1:10, more preferably 1:1.5 to 1:7.

In addition, the accuracy of the groove width and the groove depth is important for accurate control of the increased area, and accordingly the adsorption amount. Variations in groove width and groove depth each preferably do not exceed ±20% of a required value, and each more preferably fall within a range of ±10% of the required value.

In processing the plurality of grooves 18 on the surface 20 of the quartz glass member 10 with an increased exposure area, the plurality of grooves may be simultaneously processed on the surface 20 of the quartz glass member main body 14 through use of a blade with multiple peripheral cutting edges.

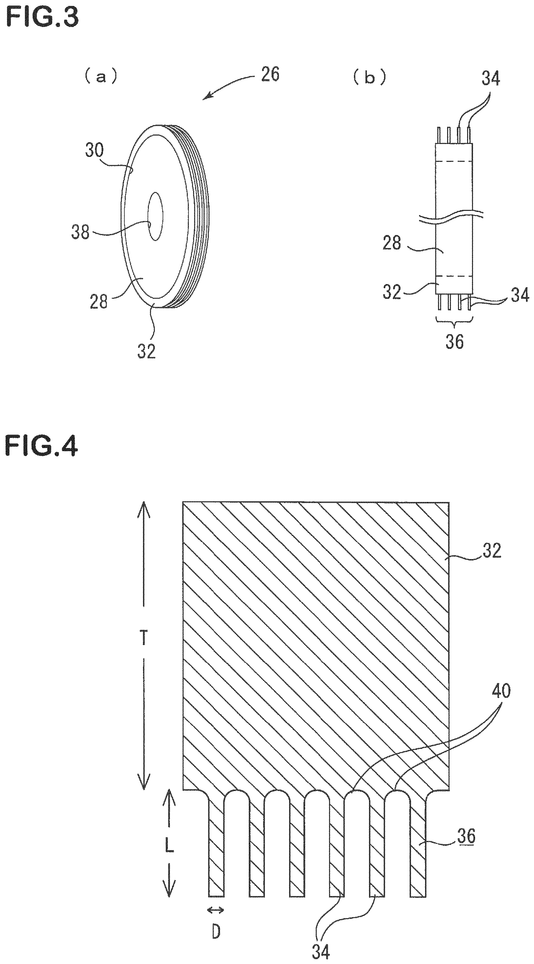

In each of FIGS. 3 to FIG. 5, a blade with multiple peripheral cutting edges of the present invention is denoted by reference numeral 26. The blade 26 with multiple peripheral cutting edges includes: a single disc-shaped base metal portion 28; a diamond abrasive grain layer base portion 32 formed on an outer periphery 30 of the disc-shaped base metal portion 28; and a diamond abrasive grain cutting edge portion 36 in which a plurality of cutting edges 34 are integrally formed so as to protrude from the diamond abrasive grain layer base portion 32.

The disc-shaped base metal portion 28 is integrally formed of a single metal, and a through hole 38, into which a rotary shaft is inserted, is formed at a center thereof. The diamond abrasive grain layer base portion 32 and the diamond abrasive grain cutting edge portion 36 are formed by fixing diamond abrasive grains. The diamond abrasive grains may be fixed by sintering the diamond abrasive grains with a metal bond or by electrodepositing the diamond abrasive grains. When the disc-shaped base metal portion 28 is integrally formed of the single metal, runout of the cutting edges at the time of high-speed rotation of the blade with multiple peripheral cutting edges can be suppressed to a significantly small degree.

FIG. 4 is an enlarged view of the diamond abrasive grain layer base portion 32 and the diamond abrasive grain cutting edge portion 36. The diamond abrasive grain cutting edge portion 36 preferably has a ratio between a cutting edge thickness D and a cutting edge length L of each of the plurality of cutting edges 34 of 1:5 or more and less than 1:20.

The number of the plurality of cutting edges 34 of the diamond abrasive grain cutting edge portion 36 is not particularly limited, but for example, the cutting edges may be arranged so that the number of the cutting edges is approximately 3 or more and less than 30. When the number of the cutting edges is increased, the number of processable grooves is increased at the same time. However, when the number of the cutting edges is excessively increased, the degree of abrasion of the cutting edges at the time of processing shows variations, with the result that variations in width and depth of the grooves to be processed are increased. An example of adopting a quadruple cutting edge as the cutting edges 34 is illustrated in FIGS. 3, and an example of adopting a sextuple cutting edge as the cutting edges 34 is illustrated in FIG. 4.

In addition, the diamond abrasive grain layer base portion 32 preferably has a thickness T twice or more as large as the cutting edge length L of each of the plurality of cutting edges 34 of the diamond abrasive grain cutting edge portion 36.

Further, the diamond abrasive grain layer base portion 32 preferably has an arc-like depression 40 formed on a surface thereof between the plurality of cutting edges 34. This is because removal of chips and the like generated through cutting is enhanced, runout of the cutting edges can be reduced by reducing a processing load, and processing accuracy is increased.

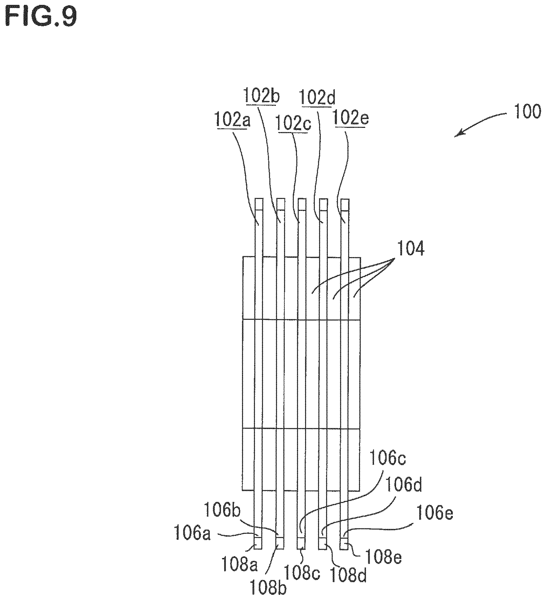

The blade 26 with multiple peripheral cutting edges of the present invention having the above-mentioned configuration enables highly accurate groove processing as compared to a related-art blade with multiple peripheral cutting edges. A related-art blade 100 with multiple peripheral cutting edges is illustrated in FIG. 9. The related-art blade 100 with multiple peripheral cutting edges is a blade with multiple peripheral cutting edges in which a plurality of blades 102a, 102b, 102c, 102d, and 102e with a single peripheral cutting edge are assembled to one another through intermediation of spacers 104. Moreover, the blades 102a, 102b, 102c, 102d, and 102e with a single peripheral cutting edge include disc-shaped base metal portions 106a, 106b, 106c, 106d, and 106e, respectively, and diamond abrasive grain cutting edges 108a, 108b, 108c, 108d, and 108e are arranged at outer peripheries of the disc-shaped base metal portions 106a, 106b, 106c, 106d, and 106e, respectively.

In the related-art blade 100 with multiple peripheral cutting edges as illustrated in FIG. 9, the plurality of blades 102a, 102b, 102c, 102d, and 102e with a single peripheral cutting edge are assembled to one another through intermediation of the spacers 104. Therefore, for example, when groove processing is to be performed at a pitch and a depth on the order of 100 µm, assembly accuracy poses a problem. In this regard, the blade 26 with multiple peripheral cutting edges of the present invention has the configuration in which the single disc-shaped base metal portion 28 is used without the use of a spacer, the diamond abrasive grain layer base portion 32 is arranged at the outer periphery 30 of the disc-shaped base metal portion 28, and further the diamond abrasive grain cutting edge portion 36 is arranged at an outer periphery of the diamond abrasive grain layer base portion 32.

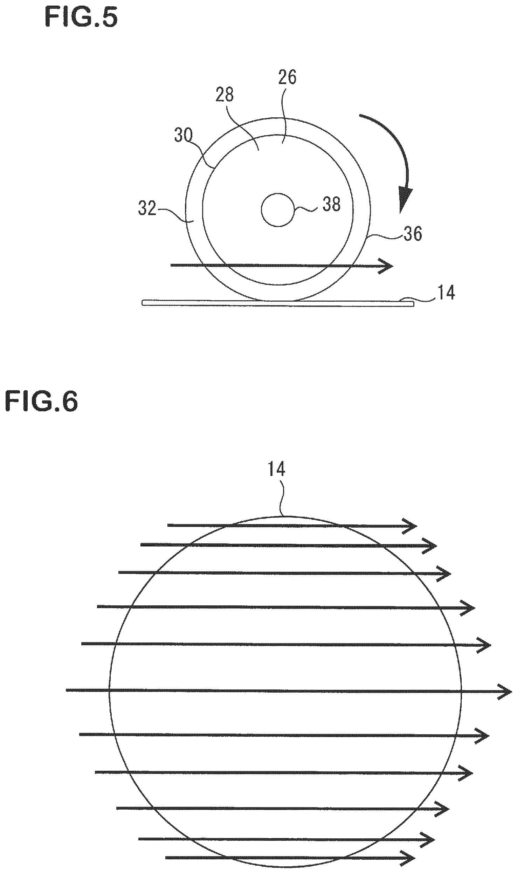

When such blade 26 with multiple peripheral cutting edges is used and caused to traverse the surface of the quartz glass member main body 14 while the blade 26 with multiple peripheral cutting edges is rotated as illustrated in FIG. 5, simultaneous processing of the plurality of grooves can be performed with the diamond abrasive grain cutting edge portion 36.

Moreover, as illustrated by the arrows of FIG. 6, when the simultaneous processing of the plurality of grooves is repeated by shifting a position, the quartz glass member with an increased exposure area of the present invention illustrated in FIGS. 1 is obtained.

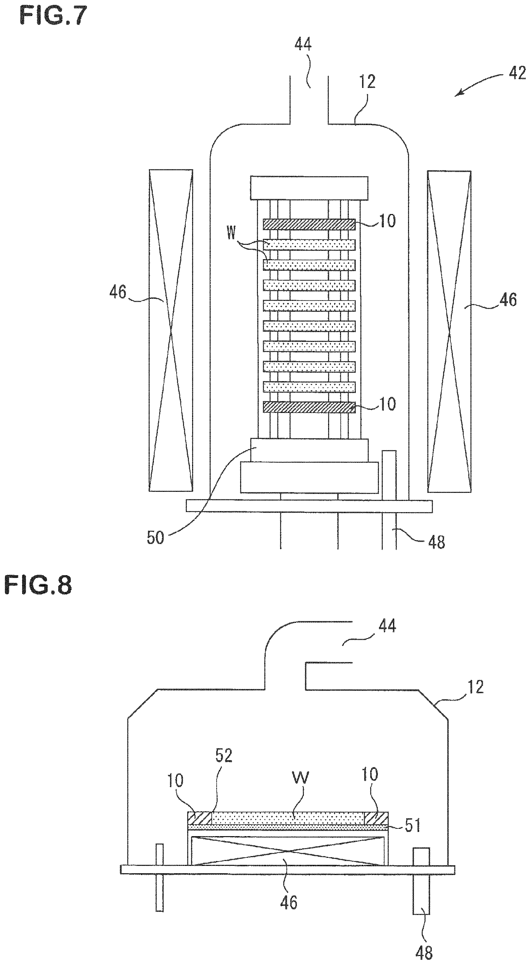

An example of a vertical heat treatment furnace is illustrated in FIG. 7. A vertical heat treatment furnace 42 includes: a reaction chamber 12 formed of quartz; a gas introduction pipe 44 configured to introduce a gas, such as a film formation treatment gas, into the reaction chamber 12; a heater 46 configured to heat the reaction chamber 12; and a gas discharge pipe 48 configured to discharge the gas in the reaction chamber 12. In addition, a wafer boat 50 is carried into the reaction chamber 12. A plurality of semiconductor substrates W (e.g., silicon wafers) are mounted on the wafer boat 50.

Moreover, the quartz glass member 10 with an increased exposure area of the present invention is mounted on each of mounting portions at an upper end and a lower end of the wafer boat 50. Under this state, the film formation treatment gas is introduced into the reaction chamber 12 from the gas introduction pipe 44 to subject the semiconductor substrates W to film formation treatment, such as CVD. Each of the semiconductor substrates W to be subjected to the film formation treatment has already had irregularities on a surface thereof through treatment. The quartz glass member 10 with an increased exposure area has an increased exposure area to the film formation treatment gas, and hence uniform film formation on the semiconductor substrates W is achieved.

### Examples

The present invention is described in more detail below by way of Examples. It is needless to say that the present invention is not limited by these Examples.

### (Examples 1 to 10)

Blades with multiple peripheral cutting edges of the present invention each including: a single disc-shaped base metal portion; a diamond abrasive grain layer base portion formed at an outer periphery of the disc-shaped base metal portion; and a diamond abrasive grain cutting edge portion obtained through a metal bond in which a plurality of cutting edges were integrally arranged so as to protrude from the diamond abrasive grain layer base portion were prepared. Quartz glass members with an increased exposure area of the present invention in each of which a plurality of irregularities were formed through use of each of those blades with multiple peripheral cutting edges were produced. The details of the blades with multiple peripheral cutting edges and the quartz glass members with an increased exposure area of Examples 1 to 10 are shown in Table 1.

**[Table 1]**

| | Blade with multiple peripheral cutting edges | | | | Quartz glass member with increased exposure area | | | | |
|---|---|---|---|---|---|---|---|---|---|
| | Number cutting edges | D:L | T:L | Depression | Shape | Target value for groove width (mm) | BW MAX | Target value for groove depth (mm) | BD MAX |
| Example 1 | 6 | 1:5 | 2:1 | Present | Y | 0.1 | 3% | 0.5 | 6% |
| Example 2 | 6 | 1:18 | 2:1 | Present | Y | 0.08 | 7% | 0.4 | 8% |
| Example 3 | 6 | 1:20 | 2:1 | Present | Y | 0.08 | 10% | 0.4 | 10% |
| Example 4 | 6 | 1:5 | 1.5:1 | Present | Y | 0.1 | 12% | 0.5 | 10% |
| Example 5 | 6 | 1:20 | 1.5:1 | Absent | Y | 0.1 | 18% | 0.5 | 14% |
| Example 6 | 4 | 1:10 | 2:1 | Present | X | 0.1 | 5% | 0.5 | 8% |
| Example 7 | 4 | 1:10 | 2:1 | Present | X | 0.08 | 6% | 0.56 | 10% |
| Example 8 | 4 | 1:10 | 2:1 | Present | X | 0.08 | 8% | 0.8 | 10% |
| Example 9 | 4 | 1:10 | 1.5:1 | Present | X | 0.08 | 10% | 0.56 | 10% |
| Example 10 | 4 | 1:20 | 1.5:1 | Absent | X | 0.08 | 17% | 0.8 | 15% |

In Table 1, the symbol "Y" in the "Shape" column represents the following member specifications: processing of irregularities on the entirety of one surface; 90° cross; a pitch of 0.5 mm; and a quartz glass member main body measuring 340 mm in outer diameter (OD)×302 mm in inner diameter (ID)×0.8 mm in thickness t (ring shape), and the symbol "X" in the "Shape" column represents the following member specifications: processing of irregularities on the entirety of one surface; parallel; a pitch of 0.5 mm; and a quartz glass member main body measuring 300 mm in outer diameter (OD)×0.8 mm in thickness t (disc shape). In addition, the symbol "BW MAX" represents the maximum variation percentage (absolute value) of the groove width, the symbol "BD MAX" represents the maximum variation percentage (absolute value) of the groove depth, the symbol "D" represents the cutting edge thickness, the symbol "L" represents the cutting edge length, and the symbol "T" represents the thickness of the base portion.

As shown in Table 1, through use of the blades with multiple peripheral cutting edges of the present invention, the quartz glass members with an increased exposure area in each of which a plurality of groove-shaped irregularities were formed and variations in groove width and groove depth of the grooves each fell within a range of 20% or less were obtained.

In addition, the variation in groove width was less than 10% in each of Examples 1, 2, and 6 to 8, and further desired results were obtained.

### (Experimental Examples 1 to 5)

Related-art blades with multiple peripheral cutting edges in each of which a plurality of single blades were assembled to one another through intermediation of spacers illustrated in FIG. 9 were prepared. Through utilization of those blades with multiple peripheral cutting edges, members having the shapes represented by the symbols "Y" and "X" similar to those of Examples 1 to 10 were produced. The details of the blades with multiple peripheral cutting edges and the quartz glass members with an increased exposure area of Experimental Examples 1 to 5 are shown in Table 2. In Table 2, the symbol "S" represents an entire width of the spacers and the blades after their assembly.

**[Table 2]**

| | Blade with multiple peripheral cutting edges | | | | Quartz glass member with increased exposure area | | | | |
|---|---|---|---|---|---|---|---|---|---|
| | Number cutting edges | D:L | S:L | Depression | Shape | Target value for groove width (mm) | BW MAX | Target value for groove depth (mm) | BD MAX |
| Experimental Example 1 | 6 | 1:5 | 2:1 | - | Y | 0.1 | 20% | 0.5 | 22% |
| Experimental Example 2 | 6 | 1:18 | 2:1 | - | Y | 0.08 | 48% | 0.4 | 20% |
| Experimental Example 3 | 6 | 1:20 | 2:1 | - | Y | 0.08 | 52% | 0.8 | 36% |
| Experimental Example 4 | 4 | 1:10 | 2:1 | - | X | 0.1 | 20% | 0.5 | 20% |
| Experimental Example 5 | 4 | 1:10 | 2:1 | - | X | 0.08 | 33% | 0.56 | 22% |

As shown in Table 2, variations in groove width and groove depth were larger in Experimental Examples 1 to 5 than in Examples 1 to 10, and the quartz glass members of Experimental Examples 1 to 5 were not suitable for practical use.

### (Example 11)

A ring-shaped quartz glass member with an increased exposure area was prepared by the same method as in Example 2. The ring-shaped quartz glass member with an increased exposure area was subjected to a film formation test of a nitride film with a film formation treatment apparatus illustrated in FIG. 8, and a treatment gas adsorption effect onto the quartz glass member with an increased exposure area was examined. As illustrated in FIG. 8, the film formation test was performed by mounting a ring-shaped quartz glass member 10 with an increased exposure area on a susceptor 51, and arranging a semiconductor substrate W to be subjected to film formation treatment on a hollow portion 52 of the ring-shaped quartz glass member 10 with an increased exposure area. In addition, as Reference Example 1, a test was performed in the same manner by mounting only the semiconductor substrate W on the susceptor 51 without arranging the quartz glass member.

When the film thickness of a film formed at a center of the surface of the substrate after film formation was defined as 1, a relative ratio in film thickness of the film between the center and an outer periphery was confirmed. The results are shown in Table 3.

### (Example 12)

An experiment was performed by the same method as in Example 11 except that a ring-shaped quartz glass member with an increased exposure area obtained by the same method as in Experimental Example 3 was used. The results are shown in Table 3.

### (Comparative Example 1)

An experiment was performed by the same method as in Example 11 except that a ring-shaped quartz glass member without a groove was used. The results are shown in Table 3.

**[Table 3]**

| | Ring-shaped quartz glass member | | | | | Surface of substrate after film formation |
|---|---|---|---|---|---|---|
| | Target value for groove width (mm) | BW MAX | Target value for groove depth (mm) | BD MAX | Shape | Ratio in film thickness (outer periphery /center) |
| Example 11 | 0.08 | 7% | 0.4 | 8% | Y | 1.05 |
| Example 12 | 0.08 | 53% | 0.8 | 36% | Y | 1.07 |
| Comparative Example 1 | - | - | - | - | Y | 1.3 |
| Reference Example 1 | Absent | | | | | 1.4 |

As apparent from Table 3, a suppressing effect on an increase in film thickness at the outer periphery exhibited by the increased exposure area was larger in each of Examples 11 and 12 than in Comparative Example 1. In addition, when Example 12, in which the ratio of the groove depth to the groove width was 10 or more, was compared to Example 11, in which the ratio of the groove depth to the groove width was 5, i.e., less than 10, which was desired, the suppressing effect on an increase in film thickness at the outer periphery in Example 12 was smaller despite that the groove depth was larger and the area was increased more. It was revealed that Examples 11 and 12 differed from each other in effectiveness of the adsorption effect.

### (Examples 13 to 15)

With regard to groove variations in a quartz glass member with an increased exposure area and variations in adsorption amount onto the quartz glass member, the variations in adsorption amount were examined by using pure water to resemble a treatment gas and based on a difference in weight of residual pure water adhering onto a surface of the quartz glass member. The evaluation was performed by the following steps 1) to 5).
1) A water tank is filled with predetermined pure water, and measured for a weight.
2) A quartz glass member (having the shape represented by the symbol "Y" or "X") is immersed in the water tank filled with pure water, and retained in water for 10 minutes.
3) Next, a product is lifted off the water surface, and retained above the water tank for 60 seconds while being separated from the water surface to cause water drops separated from the member to fall to the water tank.
4) The weight of the water tank after the treatment of the step 3) from which the member has been removed and which includes residual pure water is measured.
5) A difference between the weight measured in the step 1) and the weight measured in the step 4) is defined as the adsorption weight of pure water onto the quartz glass member.

Those steps were repeated ten times for each quartz glass member, and the examination was performed based on the "MAX-MIN" and the average of the adsorption weight.

As quartz glass members in Example 13, Example 14, and Example 15, quartz glass members with an increased exposure area obtained by the same methods as in Example 2, Example 6, and Example 9 were used, respectively. The results are shown in Table 4.

### (Comparative Example 2)

An experiment was performed by the same method as in each of Examples 13 to 15 except that a ring-shaped quartz glass member without a groove similar to that of Comparative Example 1 was used. The results are shown in Table 4.

### (Experimental Examples 6 and 7)

An experiment was performed by the same method as in each of Examples 13 to 15 except that the quartz glass member was changed. In Experimental Examples 6 and 7, quartz glass members with an increased exposure area obtained by the same methods as in Experimental Examples 4 and 5 were used, respectively. The results are shown in Table 4.

**[Table 4]**

| | Quartz glass member | | | Adsorption weight (g) | |
|---|---|---|---|---|---|
| | BW MAX | BD MAX | Shape | MAX-MIN | Average |
| Example 13 | 7% | 8% | Y | 0.2 | 1.7 |
| Example 14 | 5% | 8% | X | 0.5 | 4.8 |
| Example 15 | 10% | 10% | X | 0.7 | 4.9 |
| Comparative Example 2 | - | - | Y | 0.3 | 0.7 |
| Experimental Example 6 | 20% | 21% | X | 2.7 | 4.5 |
| Experimental Example 7 | 34% | 22% | X | 2.5 | 4.6 |

As shown in Table 4, in each of Examples 13 to 15, in which the quartz glass member with an increased exposure area having small groove variations was used, also the variation in adsorption amount was significantly small. In addition, the results of the adsorption amount of pure water in Comparative Example 2 and Example 13 agree well with the results of the suppressing effect on an increase in film thickness at the outer periphery in Comparative Example 1 and Example 11. It is revealed that a larger adsorption amount provides a larger suppressing effect on an increase in film thickness. Further, from Examples 14 and 15 and Experimental Examples 6 and 7, it is revealed that, when the accuracy of the groove width and the groove depth of the grooves shows a large variation, also the adsorption amount shows a large variation. From the fact, it can be examined that a constant adsorption amount is achieved by controlling the increased exposure area through the groove width and the groove depth of the grooves.

### Reference Signs List

10, 10A to 10D: quartz glass member with increased exposure area, 12: reaction chamber, 14: quartz glass member main body, 16: irregularity, 18: groove, 20: surface after groove processing, 22: surface before groove processing, 24a, 24b: inner side surface, 26: blade with multiple peripheral cutting edges of the present invention, 28: disc-shaped base metal portion, 30: outer periphery, 32: diamond abrasive grain layer base portion, 34: cutting edge, 36: diamond abrasive grain cutting edge portion, 38: through hole, 40: arc-like depression, 42: vertical heat treatment furnace, 44: gas introduction pipe, 46: heater, 48: gas discharge pipe, 50: wafer boat, 51: susceptor, 52: hollow portion, 100: related-art blade with multiple peripheral cutting edges, 102a, 102b, 102c, 102d, 102e: blade with single peripheral cutting edge, 104: spacer, 106a, 106b, 106c, 106d, 106e: disc-shaped base metal portion, 108a, 108b, 108c, 108d, 108e: diamond abrasive grain cutting edge, D: cutting edge thickness, L: cutting edge length, T: thickness of diamond abrasive grain layer base portion, W: semiconductor substrate.

## Claims

1. A quartz glass member with an increased exposure area, which is a quartz glass member for exposure to a film formation treatment gas to be, in film formation treatment of a semiconductor substrate, placed in a reaction chamber together with the semiconductor substrate to be subjected to the film formation treatment and exposed to the film formation treatment gas,
the quartz glass member comprising:
a quartz glass member main body; and
a plurality of irregularities formed on a surface of the quartz glass member main body,
the exposure area of the quartz glass member to the film formation treatment gas being controlled and increased.

2. A quartz glass member with an increased exposure area according to claim 1,
wherein the plurality of irregularities controlled and increased have groove shapes, and
wherein variations in groove width and groove depth of the grooves each fall within a range of ±20%.

3. A method for manufacturing the quartz glass member with an increased exposure area of claim 1 or 2, comprising performing simultaneous processing of a plurality of grooves on the surface of the quartz glass member main body through use of a blade with multiple peripheral cutting edges, to thereby form the plurality of irregularities.

4. A method for manufacturing the quartz glass member with an increased exposure area according to claim 3, wherein the quartz glass member with an increased exposure area obtained through the groove processing has, on one surface thereof having been subjected to the groove processing, a surface area three times or more as large as a surface area of the quartz glass member with an increased exposure area on the one surface before the groove processing.

5. A blade with multiple peripheral cutting edges for performing the groove processing in the method for manufacturing the quartz glass member with an increased exposure area of claim 3 or 4,
the blade with multiple peripheral cutting edges comprising:
a single disc-shaped base metal portion;
a diamond abrasive grain layer base portion formed at an outer periphery of the disc-shaped base metal portion; and
a diamond abrasive grain cutting edge portion in which a plurality of cutting edges are integrally formed so as to protrude from the diamond abrasive grain layer base portion.

6. A blade with multiple peripheral cutting edges according to claim 5, wherein the diamond abrasive grain cutting edge portion has a ratio between a cutting edge thickness and a cutting edge length of each of the plurality of cutting edges of 1:5 or more.

7. A blade with multiple peripheral cutting edges according to claim 5 or 6, wherein the diamond abrasive grain layer base portion has a thickness twice or more as large as a cutting edge length of each of the plurality of cutting edges of the diamond abrasive grain cutting edge portion.

8. A blade with multiple peripheral cutting edges according to any one of claims 5 to 7, wherein the diamond abrasive grain layer base portion has an arc-like depression formed on a surface thereof between the plurality of cutting edges.
